# EUROPÄISCHE PATENTSCHRIFT

(11) **EP 4 589 263 B1**
(45) Veröffentlichungstag und Bekanntmachung des Hinweises auf die Patenterteilung: **10.12.2025**
(21) Anmeldenummer: 24194839.7
(22) Anmeldetag: 16.08.2024
(51) Int. Cl.: G01D 11/28, G01D 13/00

(54) **SENSOR**
SENSOR
CAPTEUR

(30) Priorität: 22.01.2024 DE 202024100303 U
(43) Veröffentlichungstag der Anmeldung: 23.07.2025
(73) Patentinhaber: Leuze electronic GmbH + Co. KG, 73277 Owen/Teck (DE)
(72) Erfinder: Haberl, Paul, 80999 München (DE); Bihr, Ralf, 83278 Traunstein (DE); Wursthorn, Viktor, 72636 Frickenhausen (DE); Rapp, Tobias, 89312 Günzburg (DE)
(74) Vertreter: Ruckh, Rainer Gerhard

(56) Entgegenhaltungen:
- DE-A1- 102004 011 804
- DE-U1- 202014 009 924
- DE-U1- 202020 106 752

## Beschreibung

Die Erfindung betrifft einen Sensor.

Der Sensor dient generell zur Erfassung von Objekten in einem Erfassungsbereich. Hierzu weist der Sensor geeignete Sensorkomponenten auf, die in wenigstens einem Gehäuse integriert sind.

Der Sensor kann beispielsweise von einem optischen Sensor gebildet sein. Dann weist der Sensor wenigstens einen Lichtstrahlen emittierenden Sender und einen Lichtstrahlen empfangenden Empfänger auf, die im einfachsten Fall in einem gemeinsamen Gehäuse integriert sind. In dem Gehäuse befindet sich auch eine Auswerteeinheit, in welcher in Abhängigkeit von Empfangssignalen des Empfängers ein Objektfeststellungssignal generiert wird, das über einen Ausgang des Sensors ausgegeben wird.

Ein derartiger optischer Sensor kann ein Lichttaster, ein Distanzsensor, ein Flächendistanzsensor oder auch ein Barcodelesegerät sein.

Generell kann der optische Sensor auch zwei Gehäuse aufweisen. Beispiele hierfür sind optische Sensoren in Form einer Lichtschranke oder eines Lichtvorhangs.

Derartige Sensoren weisen typischerweise Anzeigeelemente auf, die zur optischen Anzeige von Statusmeldungen, Kontrollmeldungen, insbesondere Warn- oder Störmeldungen dienen.

Die Anzeigeelemente können in Form von Leuchtdioden gebildet sein, die sichtbares, vorzugsweise farbiges Licht emittieren.

Diese Anzeigeelemente befinden sich in Gehäuseöffnungen des Gehäuses, so dass sie von außen sichtbar sind. Da die Sensoren spezifischen Anforderungen bezüglich der Dichtigkeit genügen müssen, müssen den Anzeigeelementen zusätzliche Elemente, wie Abdeckscheiben und Dichtungen, zugeordnet sein.

Die DE 20 2020 106752 U1 zeigt einen bekannten Sensor mit einem Anzeigeelement.

Der Erfindung liegt die Aufgabe zugrunde, einen Sensor der eingangs genannten Art bereitzustellen, der rationell gefertigt werden kann und eine hohe Funktionalität aufweist.

Zur Lösung dieser Aufgabe sind die Merkmale des Anspruchs 1 vorgesehen. Vorteilhafte Ausführungsformen und zweckmäßige Weiterbildungen der Erfindung sind in den abhängigen Ansprüchen beschrieben.

Die Erfindung betrifft einen Sensor mit wenigstens einem Gehäuse, in welchem Sensorkomponenten integriert sind. Das Gehäuse weist wenigstens ein Gehäuseteil auf, welches aus einem lichtleitenden Material besteht. Das Gehäuseteil weist wenigstens ein ein Anzeigeelement ausbildendes lichtleitendes Element auf, welches eine Schrägfläche und an der Außenseite des Gehäuses eine Lichtaustrittsfläche aufweist. Von einer im Innenraum des Gehäuses angeordneten Lichtquelle emittiertes sichtbares Licht wird über die Schrägfläche in das lichtleitende Element eingekoppelt und in diesem zur Lichtaustrittsfläche geführt. Das Gehäuseteil weist einen plattenförmigen Grundkörper auf, von welchem das oder jedes lichtleitende Element hervorsteht, wobei das oder jedes lichtleitende Element einstückig mit dem plattenförmigen Grundkörper ausgebildet ist.

Der Grundgedanke der Erfindung besteht darin, ein Gehäuseteil des Gehäuses des Sensors aus einem lichtleitenden Material auszubilden.

Dieses Gehäuseteil erfüllt dann eine Doppelfunktion derart, dass es einerseits eine Wand des Gehäuses ausbildet. Zudem wird mit dem Gehäuseteil eine optische Anzeige zur Anzeige von Statusmeldungen, Kontrollmeldungen, Warnmeldungen, Störmeldungen und dergleichen realisiert. Durch diese Doppelfunktion wird einerseits eine hohe Funktionalität des Sensors erzielt. Zudem weist der Sensor damit eine kompakte Bauweise auf, wobei insbesondere vorteilhaft ist, dass nur eine geringe Anzahl von Bauteilen zur Fertigung des Sensors benötigt wird.

Erfindungsgemäß weist das Gehäuseteil zur Ausbildung von Anzeigeelementen lichtleitende Elemente auf, die Bestandteil des Gehäuseteils sind, d.h einstückig mit diesem ausgebildet sind. Im einfachsten Fall ist nur ein lichtleitendes Element vorhanden. Alternativ weist das Gehäuseteil mehrere in Abstand zueinander angeordnete lichtleitende Elemente auf, welche separate Anzeigeelemente bilden. Dabei sind die lichtleitenden Elemente vorteilhaft identisch ausgebildet.

Das bzw. jedes lichtleitende Element weist in der Innenseite des Gehäuseteils eine Schrägfläche auf, über welche sichtbares Licht einer im Innenraum angeordneten Lichtquelle in das lichtleitende Element eingekoppelt wird. Das sichtbare Licht wird dann größtenteils im lichtleitenden Element geführt und gelangt so zu einer Lichtaustrittsfläche des lichtleitenden Elements, das an der Außenseite des Gehäuseteils angeordnet ist und vorteilhaft von der dort liegenden vorderen Stirnfläche des lichtleitenden Elements gebildet ist.

Mit dem zur Lichtaustrittsfläche geführten sichtbaren Licht wird auf konstruktiv einfache Weise eine an der Außenseite des Gehäuses gut sichtbare optische Anzeige realisiert.

Erfindungsgemäß weist das Gehäuseteil einen plattenförmigen Grundkörper auf, von welchem das oder jedes lichtleitende Element hervorsteht.

Dabei ist das oder jedes lichtleitende Element einstückig mit dem plattenförmigen Grundkörper ausgebildet.

Der vorzugsweise in einer Ebene verlaufende plattenförmige Grundkörper bildet eine Wand des Gehäuses, vorzugsweise vollständig oder wenigstens teilweise, aus. Dadurch, dass das lichtleitende Element vom plattenförmigen Grundkörper hervorsteht, d.h. die Längsachse des lichtleitenden Elements geneigt vorzugsweise senkrecht zur Ebene des plattenförmigen Grundkörpers verläuft, wird mit dem lichtleitenden Element eine Vorzugsrichtung für die Lichtführung des von der Lichtquelle eingekoppelten sichtbaren Lichts vorgegeben, so dass der größte Teil des Lichts der Lichtquelle entlang des lichtleitenden Elements geführt wird und nur ein kleinerer Teil im plattenförmigen Grundkörper verläuft. Dies gewährleistet eine gut sichtbare Anzeige mittels des sichtbaren Lichts im lichtleitenden Element und dessen Lichtaustrittsfläche.

Dabei ist das lichtleitende Element zweckmäßig derart ausgebildet, dass ein Segment des lichtleitenden Elements, an welchem die Lichtaustrittsfläche vorhanden ist, über die Außenseite des plattenförmigen Grundkörpers hervorsteht. Ein Segment des lichtleitenden Elements, an welchem die Schrägfläche vorhanden ist, steht über die Innenseite des plattenförmigen Grundkörpers hervor.

Das sichtbare Licht der Lichtquelle wird somit an der Schrägfläche im Innenraum des Gehäuses in das lichtleitende Element eingekoppelt, und zwar derart, dass das Licht größtenteils in Richtung der Längsachse der lichtleitenden Elemente bis zur Lichtaustrittsfläche verläuft.

Gemäß einer vorteilhaften Ausführungsform ist das Gehäuseteil aus einem Kunststoff-Spritzgussteil gebildet.

Das Gehäuseteil kann somit rationell in einem Fertigungsprozess gefertigt werden.

Vorteilhaft ist der Kunststoff Polycarbonat oder ein Polycarbonat-Blend oder ein Polyetherimid.

Diese Kunststoffe weisen über einen hohen Temperaturbereich eine gute Formstabilität auf.

Zur weiteren Verbesserung der Formstabilität und zur Versteifung des Gehäuseteils sind vorteilhaft an der Innenseite des Gehäuseteils Rippen vorhanden, welche Versteifungselemente des Gehäuseteils bilden.

Gemäß einer vorteilhaften Ausgestaltung weist das Gehäuseteil Befestigungselemente auf.

Die Befestigungselemente erlauben vorteilhaft eine werkzeuglose Befestigung mit weiteren Komponenten des Gehäuses. Insbesondere sind die Befestigungselemente in Form von Schnapphaken ausgebildet.

Damit kann das gesamte Gehäuse des Sensors schnell und einfach ohne Einsatz von Werkzeugen montiert werden.

Ein wesentlicher Vorteil besteht weiterhin darin, dass die Befestigungselemente, ebenso wie die lichtleitenden Elemente, Bestandteile des Gehäuseteils sind, d.h. die lichtleitenden Elemente und die Befestigungselemente bilden mit dem gesamten Gehäuseteil ein einziges Teil. Dadurch wird die Anzahl an Bauteilen zur Ausbildung des Gehäuses und damit des gesamten Sensors sehr gering gehalten.

Gemäß einer konstruktiv vorteilhaften Ausgestaltung ist an einem Gehäusesegment eine Dichtung vorhanden, die eine Abdichtung gegenüber dem Gehäuseteil bewirkt.

Damit wird bei fertig montiertem Gehäuse eine Abdichtung des Gehäuseteils zu weiteren Gehäuseelementen erzielt.

Die Dichtung kann in eine Nut eingepresst werden, oder alternativ besteht die Dichtung aus einem PU-Schaum, der in die Nut eingeschäumt wird.

Vorteilhaft ist die Dichtung am Rand des Gehäuseteils umlaufend angeordnet.

Eine gleichförmige Lastverteilung und eine minimierte Beanspruchung bei Verpressen der Dichtung kann durch aussteifende Rippen erzielt werden.

Weiter vorteilhaft besteht die Dichtung aus Polyurethan oder einem Elastomer.

Die so ausgebildete Dichtung ermöglicht eine gute Dichtwirkung bei geringer Verpresskraft.

Gemäß einer vorteilhaften Ausgestaltung ist die Außenseite des Gehäuseteils mit wenigstens einer Abdeckung abdeckbar, wobei die Abdeckung wenigstens eine Öffnung aufweist, in welcher das wenigstens eine lichtleitende Element gelagert ist.

Dabei weist die Abdeckung keine oder eine geringe Transmission für sichtbares Licht auf.

Die Abdeckung oder die Abdeckungen verdecken den plattenförmigen Grundkörper des Gehäuseteils, so dass dort geführtes Licht nicht sichtbar ist.

Zweckmäßig sind die oder jede Abdeckung gelenkig an das Gehäuseteil angekoppelt und können so bei Bedarf geöffnet und wieder geschlossen werden.

Dabei weist die Abdeckung mehrere Öffnungen auf, wobei in jeder Öffnung ein lichtleitendes Element gelagert ist.

Somit ist zwar der plattenförmige Grundkörper des Gehäuseteils durch die oder alle Abdeckungen verdeckt, jedoch sind die lichtleitenden Elemente und damit die Anzeigeelemente durch die Öffnungen gut sichtbar. Ein optisches Übersprechen der einzelnen Anzeigeelemente wird dadurch vermieden.

Vorteilhaft besteht die Abdeckung aus einem Elastomer und/oder aus Polycarbonat.

Gemäß einer weiteren vorteilhaften Ausgestaltung ist im Gehäuseteil eine Durchgangsöffnung vorhanden, in welchem ein Schnittstellenelement gelagert werden kann.

Dabei kann die Durchgangsöffnung mittels der Abdeckung abgedichtet sein.

Der erfindungsgemäße Sensor kann vorteilhaft ein optischer Sensor, ein Radarsensor oder ein Ultraschallsensor sein.

Ist der Sensor als ein optischer Sensor ausgebildet, weist dieser wenigstens einen Lichtstrahlen emittierenden Sender und einen Lichtstrahlen empfangenden Empfänger auf, die im einfachsten Fall in einem gemeinsamen Gehäuse integriert sind. In dem Gehäuse befindet sich auch eine Auswerteeinheit, in welcher in Abhängigkeit von Empfangssignalen des Empfängers ein Obj ektfeststellungssignal generiert wird, das über einen Ausgang des Sensors ausgegeben wird.

Ein derartiger optischer Sensor kann ein Lichttaster, ein Distanzsensor, ein Flächendistanzsensor oder auch ein Barcodelesegerät sein.

Generell kann der optische Sensor auch zwei Gehäuse aufweisen. Beispiele hierfür sind optische Sensoren in Form einer Lichtschranke oder eines Lichtvorhangs.

Die Erfindung wird im Folgenden anhand der Zeichnungen erläutert. Es zeigen:
- Figur 1:: Schematische Darstellung eines Ausführungsbeispiels des erfindungsgemäßen Sensors.
- Figur 2:: Perspektivische Darstellung des erfindungsgemäßen Gehäuseteils für das Gehäuse des erfindungsgemäßen Sensors mit Blick auf der Frontseite des Gehäuseteils.
- Figur 3:: Perspektive Darstellung des Gehäuseteils gemäß Figur 2 mit Blick auf die Rückseite des Gehäuseteils.
- Figur 4:: Darstellung des Gehäuses des Sensors mit einer Abdeckung in einer Öffnungsstellung.
- Figur 5:: Anordnung gemäß Figur 4 mit geschlossener Abdeckung.
- Figur 6:: Draufsicht auf die Rückseite des Gehäuseteils mit daran gelagerten Abdeckungen.
- Figur 7:: Schnittdarstellung der Anordnung gemäß Figur 6.
- Figur 8:: Vergrößerte Detaildarstellung der Anordnung gemäß Figur 7.

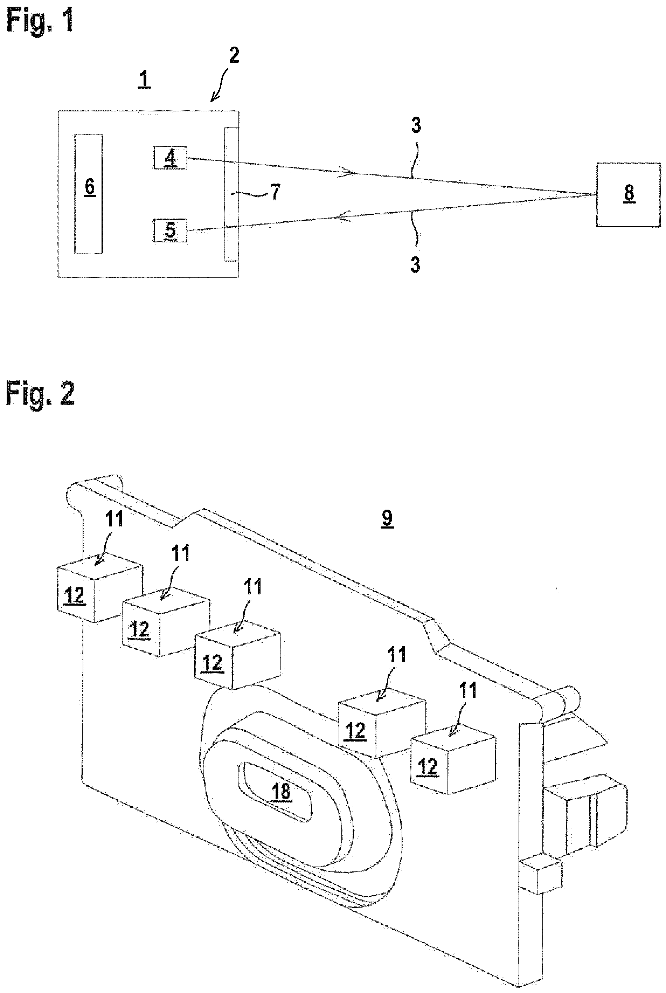

Figur 1 zeigt stark schematisiert ein Ausführungsbeispiel des erfindungsgemäßen Sensors 1, der im vorliegenden Fall ein optischer Sensor 1 ist.

Der optische Sensor ist dabei in Form eines Lichttasters ausgebildet, dessen Sensorkomponenten in einem Gehäuse 2 integriert sind. Der optische Sensor weist als Sensorkomponenten einen Lichtstrahlen 3 emittierenden Sender 4 und einen Lichtstrahlen 3 empfangenden Empfänger 5 auf. Weiterhin ist eine Auswerteeinheit 6 vorhanden, die allgemein von einer Rechnereinheit gebildet ist.

Zur Durchführung von Objektdetektionen in einem Erfassungsbereich werden die vom Sender 4 emittierten Lichtstrahlen 3 durch eine Frontscheibe 7 in der Frontwand des Gehäuses 2 in den Erfassungsbereich geführt. Die an einem Objekt 8 reflektierten Lichtstrahlen 3 werden durch die Frontscheibe 7 zurück zum Empfänger 5 geführt. In der Auswerteeinheit 6 werden die Empfangssignale des Empfängers 5 ausgewertet. Abhängig hiervon wird in der Auswerteeinheit 6 ein Objektfeststellungssignal generiert, das über einen nicht dargestellten Ausgang ausgegeben wird.

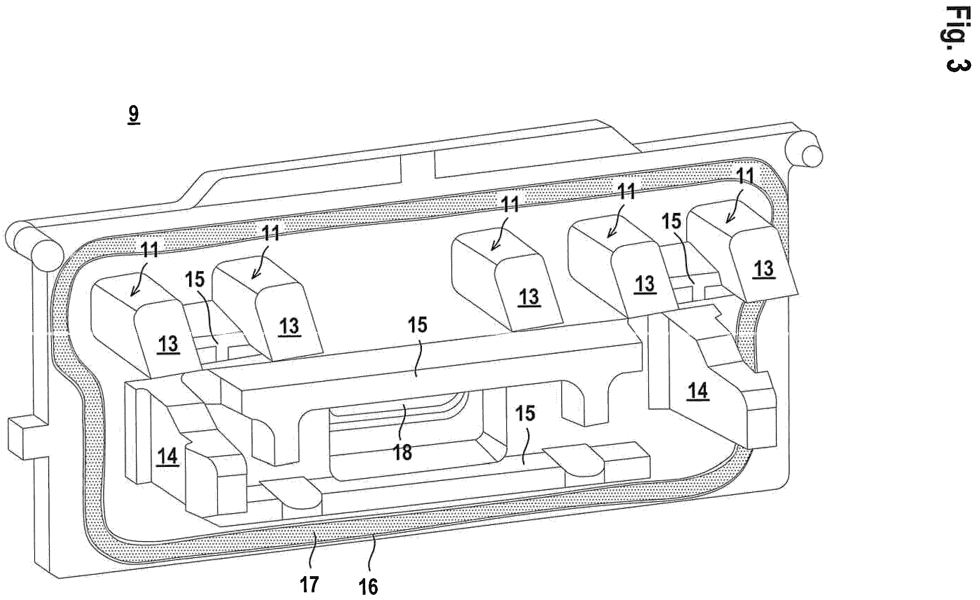

Die Figuren 2 und 3 zeigen ein aus einem lichtleitenden Material bestehendes Gehäuseteil 9, das im vorliegenden Fall eine Seiten- oder Rückwand des Gehäuses 2 des Sensors 1 ausbildet.

Das Gehäuseteil 9 ist aus einem Kunststoff-Spritzgussteil gebildet.

Der Kunststoff ist Polycarbonat oder ein Polycarbonat-Blend oder ein Polyetherimid.

Das Gehäuseteil 9 weist einen in einer Ebene verlaufenden plattenförmigen Grundkörper 10 auf, an welchem mehrere lichtleitende Elemente 11 angeordnet sind. Dabei sind die lichtleitenden Elemente 11 einstückig mit dem plattenförmigen Grundkörper 10 ausgebildet. Im vorliegenden Fall sind alle lichtleitenden Elemente 11 identisch ausgebildet. Die Längsachsen der lichtleitenden Elemente 11 verlaufen parallel zueinander und senkrecht zur Ebene des plattenförmigen Grundkörpers 10.

Wie Figur 2 zeigt, stehen quaderförmige Segmente der lichtleitenden Elemente 11 über die Außenseite des plattenförmigen Grundkörpers 10 hervor. Die vordere Stirnseite jedes Segments bildet eine Lichtaustrittsfläche 12.

Wie Figur 3 zeigt, stehen Segmente der lichtleitenden Elemente 11 über die Innenseite des plattenförmigen Grundkörpers 10 hervor und ragen in den Innenraum des Gehäuses 2. Die hintere Stirnfläche jedes lichtleitenden Elements 11 ist im vorliegenden Fall als Schrägfläche 13 ausgebildet. Diese kann mit einer Umlenkfläche für eingekoppeltes sichtbares Licht zusammen wirken.

Jedes lichtleitende Element 11 bildet ein optisches Anzeigeelement. Hierzu wird von einer (nicht dargestellten) Lichtquelle im Innenraum des Gehäuses 2 sichtbares Licht über die Schrägfläche 13 in das jeweilige lichtleitende Element 11 eingekoppelt. Durch die Geometrie des lichtleitenden Elements 11 und dessen Anordnung relativ zum plattenförmigen Grundkörper 10 ist gewährleistet, dass der größte Teil des sichtbaren Lichts im lichtleitenden Element 11 verläuft und nur ein kleiner Teil sichtbaren Lichts im plattenförmigen Grundkörper 10 verläuft. Das im lichtleitenden Element 11 geführte sichtbare Licht wird dann bis zur Lichtaustrittsfläche 12 geführt und ist dort für einen Benutzer sichtbar, wodurch das Anzeigeelement gebildet wird.

Wie aus Figur 3 ersichtlich münden an der Innenseite des Gehäuseteils 9 zwei identisch ausgebildete und spiegelsymmetrisch zur Mittelebene des Grundteils angeordnete Schnapphaken 14 aus. Die Schnapphaken 14 sind Bestandteil des Gehäuseteils 9, d.h. einstückig mit dem plattenförmigen Grundkörper 10 ausgebildet. Mit den Schnapphaken 14 kann das Gehäuseteil 9 an weiteren Gehäuseelementen des Gehäuses 2 befestigt werden.

Weiterhin münden an der Innenseite des Gehäuseteils 9 Rippen 15 aus. Auch die Rippen 15 sind einstückig mit dem plattenförmigen Grundkörper 10 ausgebildet. Die Rippen 15 dienen zur Versteifung des Gehäuseteils 9.

Weiterhin zeigt Figur 3 eine Nut 16 mit darin liegender Dichtung, die an einem weiteren Gehäuseelement angeordnet ist. Mit der Dichtung 17 wird die Nahtstelle zwischen dem Gehäuseteil 9 und dem weiteren Gehäuseelement des Gehäuses 2 abgedichtet.

Vorteilhaft besteht die Dichtung 17 aus Polyurethan oder einem Elastomer.

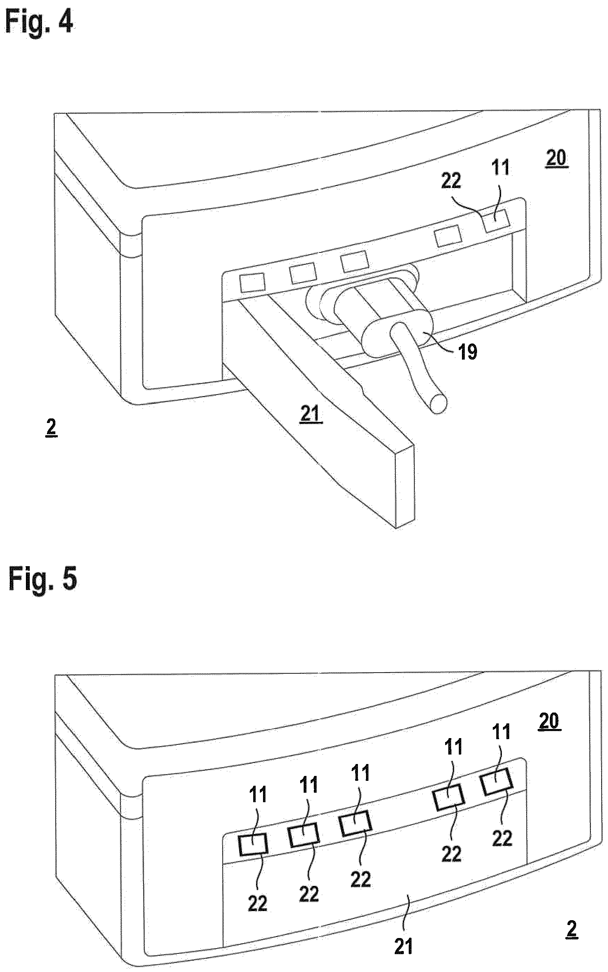

Wie Figur 2 zeigt, weist das Gehäuseteil 9 eine Durchgangsöffnung 18 auf, in welcher ein Schnittstellenelement 19, wie z.B. ein USB-Stecker (dargestellt in Figur 4), gelagert werden kann.

Die Figuren 4 und 5 zeigen jeweils eine perspektivische Teildarstellung des Gehäuses 2 des Sensors 1.

Wie Figur 5 zeigt, ist die Seitenwand des Gehäuses 2, das von dem erfindungsgemäßen Gehäuseteil 9 gebildet ist, an der Außenseite mit zwei Abdeckungen 20, 21 abgedeckt.

Die Abdeckungen 20, 21 bestehen aus optisch nicht transparentem Material, insbesondere aus einem Elastomer.

Die zweite Abdeckung 21 weist Öffnungen 22 auf, durch welche die die Anzeigeelemente bildenden lichtleitenden Elemente 11 ragen, so dass die Anzeigeelemente gut sichtbar sind.

Ein Teil der zweiten Abdeckung 21 ist gelenkig ausgebildet und kann so aus der Schließstellung gemäß Figur 5 in eine Öffnungsstellung (Figur 4) aufgeklappt werden. Dann liegt die Durchgangsöffnung 18 frei, so dass dort das Schnittstellenelement 19 angeschlossen werden kann.

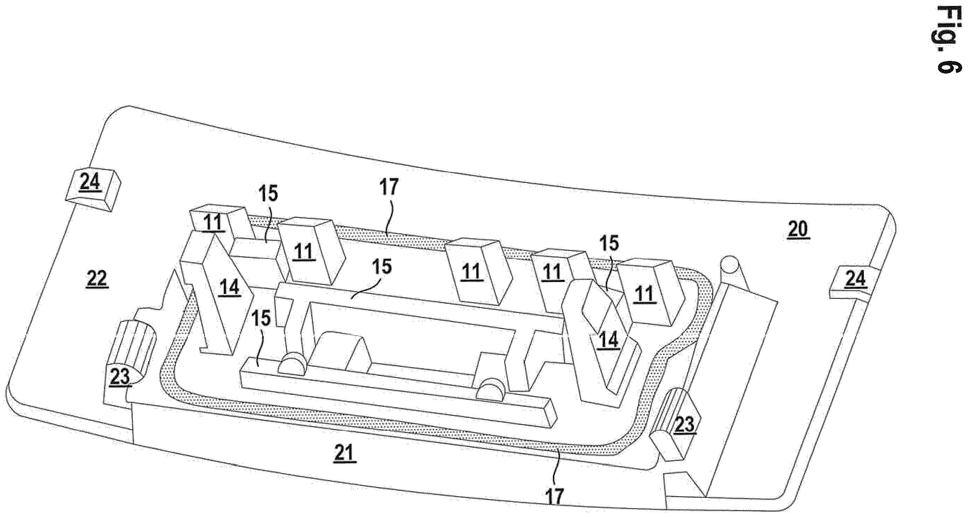

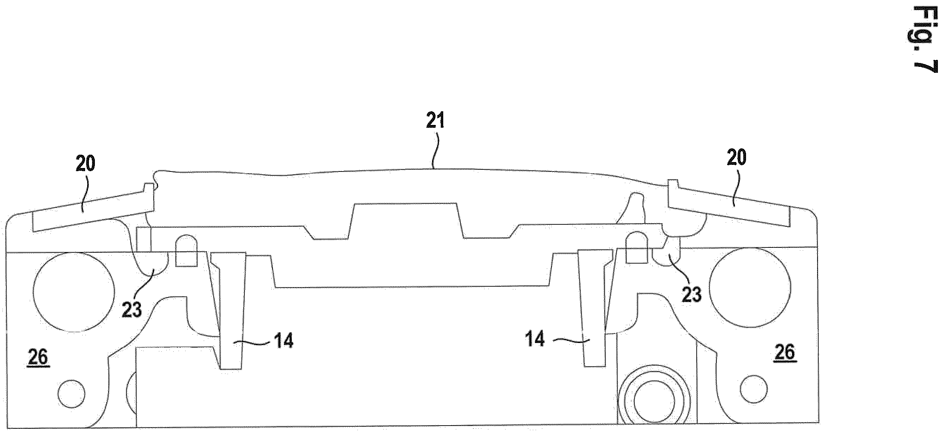

Die Figuren 6 und 7 zeigen die Rückseite des Gehäuseteils 9 mit den beiden Abdeckungen 20, 21. An der ersten Abdeckung 20 befinden sich weitere Schnapphaken 23, 24. Die Schnapphaken 23 verbinden die Abdeckung 20, 21 mit dem Gehäuseanteil 9. Die Schnapphaken 24 dienen zur Befestigung des Gehäuseteils 9 mit weiteren Gehäuseelementen.

Ein die Durchgangsöffnung 18 begrenztes Randsegment bildet, wie Figur 6 zeigt, eine konische Dichtfläche, an welcher die Abdeckung 21 dichtend angelegt werden kann.

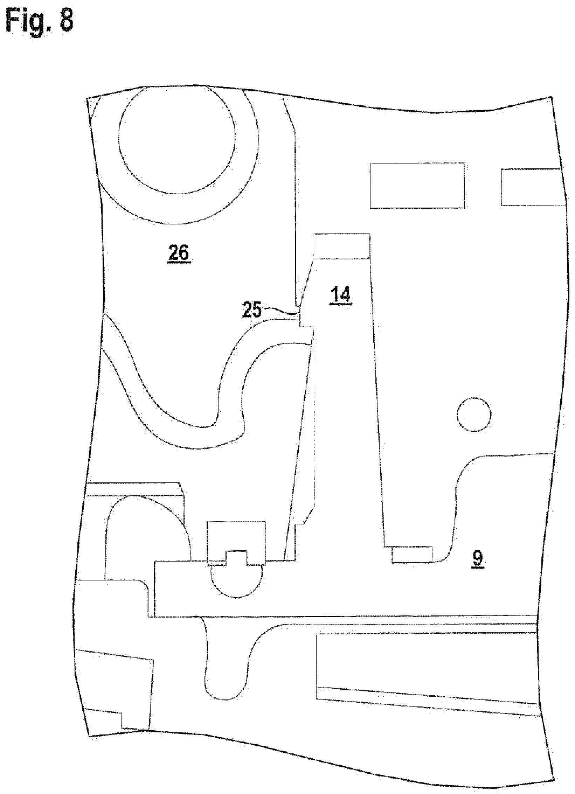

Die Detaildarstellung gemäß Figur 8 zeigt den verbreiterten Querschnitt eines Schnapphakens 14 im Bereich dessen Fußgrunds an der Ausmündung am Gehäuseteil 9.

Ein Rasthaken 25 am Schnapphaken 14 ist an einem weiteren Gehäusesegment 26 eingerastet.

### Bezugszeichenliste

- (1): Sensor
- (2): Gehäuse
- (3): Lichtstrahl
- (4): Sender
- (5): Empfänger
- (6): Auswerteeinheit
- (7): Frontscheibe
- (8): Objekt
- (9): Gehäuseteil
- (10): plattenförmiger Grundkörper
- (11): lichtleitendes Element
- (12): Lichtaustrittsfläche
- (13): Schrägfläche
- (14): Schnapphaken
- (15): Rippe
- (16): Nut
- (17): Dichtung
- (18): Durchgangsöffnung
- (19): Schnittstellenelement
- (20): Abdeckung
- (21): Abdeckung
- (22): Öffnung
- (23): Schnapphaken
- (24): Schnapphaken
- (25): Rasthaken
- (26): Gehäusesegment

## Patentansprüche

1. Sensor (1) mit wenigstens einem Gehäuse (2), in welchem Sensorkomponenten integriert sind, **dadurch gekennzeichnet, dass** das Gehäuse (2) wenigstens ein Gehäuseteil (9) aufweist, welches aus einem lichtleitenden Material besteht, dass das Gehäuseteil (9) wenigstens ein ein Anzeigeelement ausbildendes lichtleitendes Element (11) aufweist, welches eine Schrägfläche (13) und an der Außenseite des Gehäuses (2) eine Lichtaustrittsfläche (12) aufweist, wobei von einer im Innenraum des Gehäuses (2) angeordneten Lichtquelle emittiertes sichtbares Licht über die Schrägfläche (13) in das lichtleitende Element (11) eingekoppelt und in diesem zur Lichtaustrittsfläche (12) geführt wird, und dass das Gehäuseteil (9) einen plattenförmigen Grundkörper (10) aufweist, von welchem das oder jedes lichtleitende Element (11) hervorsteht, wobei das oder jedes lichtleitende Element (11) einstückig mit dem plattenförmigen Grundkörper (10) ausgebildet ist.

2. Sensor (1) nach Anspruch 1, **dadurch gekennzeichnet, dass** das Gehäuseteil (9) aus einem Kunststoff-Spritzgussteil gebildet ist.

3. Sensor (1) nach Anspruch 2, **dadurch gekennzeichnet, dass** der Kunststoff Polycarbonat oder ein Polycarbonat-Blend oder ein Polyetherimid ist.

4. Sensor (1) nach einem der Ansprüche 1 bis 3, **dadurch gekennzeichnet, dass** die Längsachse des lichtleitenden Elements (11) senkrecht zur Ebene des plattenförmigen Grundkörpers (10) verläuft.

5. Sensor (1) nach einem der Ansprüche 1 bis 4, **dadurch gekennzeichnet, dass** ein Segment des lichtleitenden Elements (11), an welchem die Lichtaustrittsfläche (12) vorhanden ist, über die Außenseite des plattenförmigen Grundkörpers (10) hervorsteht, und dass ein Segment des lichtleitenden Elements (11), an welchem die Schrägfläche (13) vorhanden ist, über die Innenseite des plattenförmigen Grundkörpers (10) hervorsteht.

6. Sensor (1) nach Anspruch 5, **dadurch gekennzeichnet, dass** an der Innenseite des Gehäuseteils (9) Rippen (15) vorhanden sind, welche Versteifungselemente des Gehäuseteils (9) bilden.

7. Sensor (1) nach einem der Ansprüche 1 bis 6, **dadurch gekennzeichnet, dass** das Gehäuseteil (9) mehrere in Abstand zueinander angeordnete lichtleitende Elemente (11) aufweist, welche separate Anzeigeelemente bilden.

8. Sensor (1) nach einem der Ansprüche 1 bis 7, **dadurch gekennzeichnet, dass** das Gehäuseteil (9) Befestigungselemente aufweist, welche insbesondere in Form von Schnapphaken (14) ausgebildet sind.

9. Sensor (1) nach einem der Ansprüche 1 bis 8, **dadurch gekennzeichnet, dass** an einem weiteren Gehäuseelement eine Dichtung (17) vorhanden ist, die eine Abdichtung gegenüber dem Gehäuseteil (9) besteht.

10. Sensor (1) nach Anspruch 9, **dadurch gekennzeichnet, dass** die Dichtung (17) aus Polyurethan oder einem Elastomer besteht, und/oder dass die Dichtung (17) am Rand des Gehäuseteils (9) umlaufend angeordnet ist.

11. Sensor (1) nach einem der Ansprüche 1 bis 10, **dadurch gekennzeichnet, dass** der Sensor wenigstens eine Abdeckung aufweist und die Außenseite des Gehäuseteils (9) mit der wenigstens einen Abdeckung (20, 21) abdeckbar ist, wobei die Abdeckung (20, 21) wenigstens eine Öffnung (22) aufweist, in welcher das wenigstens eine lichtleitende Element (11) gelagert ist.

12. Sensor (1) nach Anspruch 11, **dadurch gekennzeichnet, dass** die Abdeckung (20, 21) mehrere Öffnungen (22) aufweist, wobei in jeder Öffnung (22) ein lichtleitendes Element (11) gelagert ist.

13. Sensor (1) nach einem der Ansprüche 11 oder 12, **dadurch gekennzeichnet, dass** die Abdeckung (20, 21) keine oder eine geringe Transmission für sichtbares Licht aufweist, und/oder dass die Abdeckung (20, 21) aus einem Elastomer besteht.

14. Sensor (1) nach einem der Ansprüche 1 bis 13, **dadurch gekennzeichnet, dass** im Gehäuseteil (9) eine Durchgangsöffnung (18) vorhanden ist, in welchem ein Schnittstellenelement (19) gelagert werden kann, wobei die Durchgangsöffnung (18) mittels der Abdeckung (21) abgedichtet ist.

15. Sensor (1) nach einem der Ansprüche 1 bis 14, **dadurch gekennzeichnet, dass** dieser ein optischer Sensor, ein Radarsensor oder ein Ultraschallsensor ist.

## Claims

1. Sensor (1) with at least one housing (2) in which sensor components are integrated, **characterised in that** the housing (2) has at least one housing part (9) which consists of a light-conducting material, **in that** the housing part (9) has at least one light-conducting element (11) forming a display element, which has an inclined surface (13) and a light exit surface (12) on the outside of the housing (2), wherein visible light emitted by a light source arranged in the interior of the housing (2) is coupled into the light-conducting element (11) via the inclined surface (13) and guided therein to the light exit surface (12), and that the housing part (9) has a plate-shaped base body (10) from which the or each light-conducting element (11) protrudes, wherein the or each light-conducting element (11) is formed integrally with the plate-shaped base body (10).

2. Sensor (1) according to claim 1, **characterised in that** the housing part (9) is formed from a plastic injection-moulded part.

3. Sensor (1) according to claim 2, **characterised in that** the plastic is polycarbonate or a polycarbonate blend or a polyetherimide.

4. Sensor (1) according to one of claims 1 to 3, **characterised in that** the longitudinal axis of the light-conducting element (11) runs perpendicular to the plane of the plate-shaped base body (10).

5. Sensor (1) according to one of claims 1 to 4, **characterised in that** a segment of the light-conducting element (11) on which the light-emitting surface (12) is located protrudes beyond the outer side of the plate-shaped base body (10), and **in that** a segment of the light-conducting element (11) on which the inclined surface (13) is present protrudes beyond the inside of the plate-shaped base body (10).

6. Sensor (1) according to claim 5, **characterised in that** ribs (15) are provided on the inside of the housing part (9), which ribs form stiffening elements of the housing part (9).

7. Sensor (1) according to one of claims 1 to 6, **characterised in that** the housing part (9) has several light-conducting elements (11) arranged at a distance from each other, which form separate display elements.

8. Sensor (1) according to one of claims 1 to 7, **characterised in that** the housing part (9) has fastening elements which are designed in particular in the form of snap hooks (14).

9. Sensor (1) according to one of claims 1 to 8, **characterised in that** a seal (17) is provided on a further housing element, which forms a seal with respect to the housing part (9).

10. Sensor (1) according to claim 9, **characterised in that** the seal (17) is made of polyurethane or an elastomer, and/or that the seal (17) is arranged around the edge of the housing part (9).

11. Sensor (1) according to one of claims 1 to 10, **characterised in that** the sensor has at least one cover and the outside of the housing part (9) can be covered with the at least one cover (20, 21), wherein the cover (20, 21) has at least one opening (22) in which the at least one light-conducting element (11) is mounted.

12. Sensor (1) according to claim 11, **characterised in that** the cover (20, 21) has several openings (22), wherein a light-conducting element (11) is mounted in each opening (22).

13. Sensor (1) according to one of claims 11 or 12, **characterised in that** the cover (20, 21) has no or low transmission for visible light, and/or that the cover (20, 21) consists of an elastomer.

14. Sensor (1) according to one of claims 1 to 13, **characterised in that** there is a through-opening (18) in the housing part (9) in which an interface element (19) can be mounted, the through-opening (18) being sealed by means of the cover (21).

15. Sensor (1) according to one of claims 1 to 14, **characterised in that** it is an optical sensor, a radar sensor or an ultrasonic sensor.

## Revendications

1. Capteur (1) comprenant au moins un boîtier (2) dans lequel sont intégrés des composants du capteur, **caractérisé en ce que** le boîtier (2) comporte au moins une partie boîtier (9) qui est constituée d'un matériau conducteur de lumière, **en ce que** la partie boîtier (9) comporte au moins un élément conducteur de lumière (11) formant un élément d'affichage, qui présente une surface inclinée (13) et, sur la face extérieure du boîtier (2), une surface de sortie de lumière (12), la lumière visible émise par une source lumineuse disposée à l'intérieur du boîtier (2) étant couplée dans l'élément conducteur de lumière (11) par l'intermédiaire de la surface inclinée (13) et guidée dans celui-ci vers la surface de sortie de lumière (12), et que la partie boîtier (9) présente un corps de base en forme de plaque (10) duquel ledit ou chaque élément conducteur de lumière (11) fait saillie, ledit ou chaque élément conducteur de lumière (11) étant formé d'un seul tenant avec le corps de base en forme de plaque (10).

2. Capteur (1) selon la revendication 1, **caractérisé en ce que** la partie boîtier (9) est formée d'une pièce moulée par injection en matière plastique.

3. Capteur (1) selon la revendication 2, **caractérisé en ce que** la matière plastique est du polycarbonate ou un mélange de polycarbonate ou un polyétherimide.

4. Capteur (1) selon l'une des revendications 1 à 3, **caractérisé en ce que** l'axe longitudinal de l'élément conducteur de lumière (11) s'étend perpendiculairement au plan du corps de base en forme de plaque (10).

5. Capteur (1) selon l'une des revendications 1 à 4, **caractérisé en ce qu'**un segment de l'élément conducteur de lumière (11), sur lequel se trouve la surface de sortie de lumière (12), dépasse de la face extérieure du corps de base en forme de plaque (10), et **en ce qu'**un segment de l'élément conducteur de lumière (11) sur lequel se trouve la surface inclinée (13) dépasse de la face intérieure du corps de base en forme de plaque (10).

6. Capteur (1) selon la revendication 5, **caractérisé en ce que** des nervures (15) sont présentes sur la face intérieure de la partie boîtier (9), lesquelles nervures forment des éléments de renfort de la partie boîtier (9).

7. Capteur (1) selon l'une des revendications 1 à 6, **caractérisé en ce que** la partie boîtier (9) comporte plusieurs éléments conducteurs de lumière (11) disposés à distance les uns des autres, qui forment des éléments d'affichage séparés.

8. Capteur (1) selon l'une des revendications 1 à 7, **caractérisé en ce que** la partie boîtier (9) comporte des éléments de fixation qui sont notamment réalisés sous la forme de crochets à encliqueter (14).

9. Capteur (1) selon l'une des revendications 1 à 8, **caractérisé en ce qu'**un joint d'étanchéité (17) est prévu sur un autre élément du boîtier, lequel joint d'étanchéité assure l'étanchéité par rapport à la partie boîtier (9).

10. Capteur (1) selon la revendication 9, **caractérisé en ce que** le joint d'étanchéité (17) est en polyuréthane ou en élastomère, et/ou **en ce que** le joint d'étanchéité (17) est disposé sur tout le pourtour du bord de la partie boîtier (9).

11. Capteur (1) selon l'une des revendications 1 à 10, **caractérisé en ce que** le capteur comporte au moins un couvercle et que la face extérieure de la partie boîtier (9) peut être recouverte par ledit au moins un couvercle (20, 21), le couvercle (20, 21) comportant au moins une ouverture (22) dans laquelle est logé ledit au moins un élément conducteur de lumière (11).

12. Capteur (1) selon la revendication 11, **caractérisé en ce que** le couvercle (20, 21) comporte plusieurs ouvertures (22), un élément conducteur de lumière (11) étant logé dans chaque ouverture (22).

13. Capteur (1) selon l'une des revendications 11 ou 12, **caractérisé en ce que** le couvercle (20, 21) présente une transmission nulle ou faible pour la lumière visible, et/ou **en ce que** le couvercle (20, 21) est constitué d'un élastomère.

14. Capteur (1) selon l'une des revendications 1 à 13, **caractérisé en ce qu'**il est prévu dans la partie de boîtier (9) une ouverture de passage (18) dans laquelle peut être logé un élément d'interface (19), l'ouverture de passage (18) étant obturée de manière étanche au moyen du couvercle (21).

15. Capteur (1) selon l'une des revendications 1 à 14, **caractérisé en ce qu'**il s'agit d'un capteur optique à effet photoélectrique, d'un capteur radar ou d'un capteur à ultrasons.
